# EUROPEAN PATENT APPLICATION

(11) **EP 3 761 298 A1**
(43) Date of publication of application: **06.01.2021**
(21) Application number: 19211805.7
(22) Date of filing: 27.11.2019
(51) Int. Cl.: G09G 3/20, H04M 1/02

(54) **TERMINAL DEVICE AND DISPLAY METHOD**

(30) Priority: 01.07.2019 CN 201910586889
(71) Applicant: Beijing Xiaomi Mobile Software Co., Ltd., Beijing 100085 (CN)
(72) Inventor: ZHAO, Ming, Haidian District, Beijing 100085 (CN)
(74) Representative: Gevers Patents

(57) **Abstract**

The present disclosure relates to a terminal device and a display method. The terminal device at least includes: a first screen component, having a first opening; an image acquisition component, having a light-sensitive surface and configured to sense ambient light based on the light-sensitive surface to generate an image when the first opening is opened; and a second screen component. When the second screen component is at a first position, the first opening is opened; and when the second screen component is at a second position, the second screen component closes the first opening to cover the light-sensitive surface and performs joint display with the first screen component. Therefore, a position of a second screen may be adjusted to achieve a full-screen display effect.

## Description

This application claims priority to Chinese patent application No. 201910586889.9 filed on July 01, 2019, the disclosure of which is incorporated herein by reference in its entirety.

### TECHNICAL FEILD

The present disclosure relates to the technical field of electronic devices, and more particularly, to a terminal device and a display method.

### BACKGROUND

Along with the development of terminal technologies and popularization of intelligent terminal devices, there is a growing pursuit for full screens with high screen-to-body ratios. However, a front camera of an existing terminal device occupies a certain space of a screen, resulting in reduction of a screen-to-body ratio of the terminal device, and thus displaying of the terminal device is limited and a user experience is affected.

### SUMMARY

The present disclosure provides a terminal device and a display method.

According to a first aspect of embodiments of the present disclosure, a terminal device is provided, which may at least include: a first screen component, having a first opening; an image acquisition component, having a light-sensitive surface and configured to sense ambient light based on the light-sensitive surface when the first opening is opened; and a second screen component and generate an image. When the second screen component is at a first position, the first opening may be opened; and when the second screen component is at a second position, the second screen component may close the first opening to cover the light-sensitive surface and perform joint display with the first screen component.

In an embodiment, the terminal device may further include:
a driving component, connected with the second screen component and configured to drive the second screen component to move between the first position and the second position.

In an embodiment, the driving component may include:
a first magnetic portion, including a coil and configured to generate a magnetic force based on a current in the coil;
a second magnetic portion, configured to rotate about a rotating axis by the magnetic force; and
a transmission portion, connected with the second magnetic portion and the second screen component, and configured to rotate along with rotation of the second magnetic portion to drive the second screen component to move between the first position and the second position.

In an embodiment, the first magnetic portion may be configured to generate a magnetic force in a second direction based on a current in a first direction within the coil and generate a magnetic force in a fourth direction based on a current in a third current within the coil;
the second magnetic portion may be configured to move about the rotating axis in a first clock direction by the magnetic force in the second direction, and move about the rotating axis in a second clock direction by the magnetic force in the fourth direction, the first clock direction and the second clock direction being opposite rotating directions; and
the transmission portion may be configured to: when moving about the rotating axis in the first clock direction along with rotation of the second magnetic portion, drive the second screen component to move from the first position to the second position; and when moving about the rotating axis in the second clock direction along with rotation of the second magnetic portion, drive the second screen component to move from the second position to the first position.

In an embodiment, the terminal device may further include:
a movement trajectory limit component, positioned between the first position and the second position,
the driving component is configured to drive the second screen component to move along the movement trajectory limit component between the first position and the second position; and
a second opening, positioned between the second screen component and the image acquisition component, where the second opening is aligned with the first opening and configured to: when the first opening is opened, expose the light-sensitive surface of the image acquisition component to sense the ambient light.

In an embodiment, the terminal device may further include:
a connecting component, fixedly connected with the second screen component.

The driving component may be connected with the connecting component and configured to drive the second screen component to move along the movement trajectory limit component between the first position and the second position by driving movement of the connecting component.

In an embodiment, the movement trajectory limit component may be provided with an arc moving groove.

The driving component may penetrate through the arc moving groove to be connected with the connecting component and configured to drive the connecting component to move along the arc moving groove.

In an embodiment, a connecting groove may be formed in the connecting component; and
the driving component maybe arranged to sequentially penetrate through the arc moving groove and the connecting groove to be connected with the connecting component.

According to a second aspect of the embodiments of the present disclosure, a display method is provided, which may include that the following operations.

According to a second aspect of the embodiments of the present disclosure, a display method is provided, which may include that the following operations. A second screen component is driven to move between a first position and a second position. When the second screen component is at the first position, a first opening of a first screen component is opened, ambient light is sensed through the opened first opening based on a light-sensitive surface of an image acquisition component, and an image is generated. When the second screen component is at the second position, the second screen component closes the first opening to cover the light-sensitive surface of the image acquisition component and performs joint display with the first screen component.

In an embodiment, the operation that the second screen component is driven to move between the first position and the second position may include that:
the second screen component is driven to move between the first position and the second position by using a driving component connected with the second screen component.

In an embodiment, the operation that the second screen component is driven based on the driving component connected with the second screen component to move between the first position and the second position may include that:
a magnetic force is generated based on a current in a coil of a first magnetic portion of the driving component;
a second magnetic portion of the driving component is driven by the magnetic force to rotate about a rotating axis; and
the second screen component is driven to move between the first position and the second position by using a transmission portion, which rotates along with rotation of the second magnetic portion, of the driving component.

In an embodiment, the operation that the magnetic force is generated based on the current in the coil of the first magnetic portion of the driving component may include that:
a magnetic force of a second direction is generated based on a current in a first direction within the coil; and
a magnetic force in a fourth direction is generated based on a current in a third direction within the coil.

In an embodiment, the operation that the second magnetic portion of the driving component is driven by the magnetic force to rotate about the rotating axis may include that:
the second magnetic portion is driven by the magnetic force in the second direction to rotate about the rotating axis in a first clock direction;
or,
the second magnetic portion is driven by the magnetic force in the fourth direction to rotate about the rotating axis in a second clock direction, the first clock direction and the second clock direction being opposite rotating directions.

In an embodiment, the operation that the second screen component is driven to move between the first position and the second position by using the transmission portion, which rotates along with rotation of the second magnetic portion, of the driving component may include that:
the second screen component is driven to move from the first position to the second position by using a second end of the transmission portion that rotates along with rotation of the second magnetic portion about the rotating axis in the first clock direction; or,
the second screen component is driven to move from the second position to the first position by using the second end of the transmission portion that rotates along with rotation of the second magnetic portion about the rotating axis in the second clock direction.

The technical solutions provided by embodiments of the present disclosure may have the following beneficial effects.

When the image acquisition component is required to generate the image, the second screen component is positioned at the first position, and the light-sensitive surface of the image acquisition component can sense the ambient light to generate the image through the first opening to smoothly complete image acquisition in condition that the image acquisition component does not occupy a display area of the terminal device. Meanwhile, when the image acquisition component is not required to generate the image, the second screen component moves from the first position to the second position, and the second screen component performs joint display with the first screen component. Therefore, by adjustment of a position of the second screen component, on one hand, the light-sensitive surface of the image acquisition component can be exposed for selfie when a user is desired to take a selfie; and on the other hand, when the user requires the terminal device to display normally, the first opening can be covered by the second screen component so as to achieve a visual full-screen display effect.

It is to be understood that the above general descriptions and detailed descriptions below are only exemplary and explanatory and not intended to limit the present disclosure.

### BRIEF DESCRIPTION OF THE DRAWINGS

The accompanying drawings referred to in the specification are a part of this disclosure, and provide illustrative embodiments consistent with the present disclosure and, serve to illustrate some embodiments of the present disclosure together with the detailed description.
FIG. 1 is a first structure diagram of a terminal device according to some embodiments of the present disclosure.
FIG. 2 is a second structure diagram of a terminal device according to some embodiments of the present disclosure.
FIG. 3 is a third structure diagram of a terminal device according to some embodiments of the present disclosure.
FIG. 4 is a fourth structure diagram of a terminal device according to some embodiments of the present disclosure.
FIG. 5 is a fifth structure diagram of a terminal device according to some embodiments of the present disclosure.
FIG. 6 is a sixth structure diagram of a terminal device according to some embodiments of the present disclosure.
FIG. 7 is a first schematic diagram illustrating movement of a second screen component according to some embodiments of the present disclosure.
FIG. 8 is a second schematic diagram illustrating movement of a second screen component according to some embodiments of the present disclosure.
FIG. 9 is a third schematic diagram illustrating movement of a second screen component according to some embodiments of the present disclosure.
FIG. 10 is a fourth schematic diagram illustrating movement of a second screen component according to some embodiments of the present disclosure.
FIG. 11 is a fifth schematic diagram illustrating movement of a second screen component according to some embodiments of the present disclosure.
FIG. 12 is a sixth schematic diagram illustrating movement of a second screen component according to some embodiments of the present disclosure.
FIG. 13 is a seventh structure diagram of a terminal device according to some embodiments of the present disclosure.
FIG. 14 is a flowchart illustrating a display method according to some embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present disclosure. Instead, they are merely examples of apparatuses and methods consistent with aspects related to the present disclosure as recited in the appended claims.

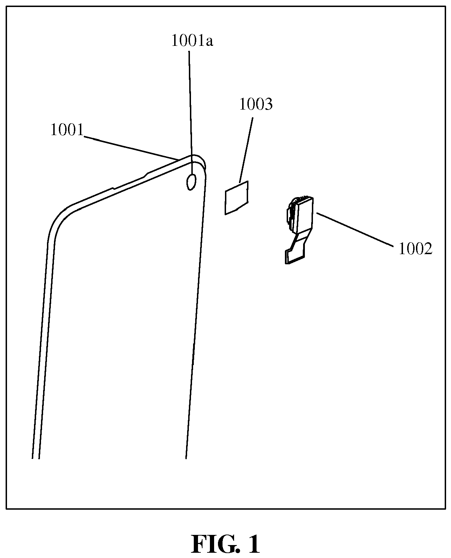

FIG. 1 is a first structure diagram of a terminal device according to some embodiments of the present disclosure. As shown in FIG. 1, the terminal device 1000 at least includes a first screen component 1001, an image acquisition component 1002 and a second screen component 1003.

The first screen component 1001 has a first opening 1001a.

The image acquisition component 1002 has a light-sensitive surface and is configured to sense ambient light based on the light-sensitive surface to generate an image when the first opening is opened.

When the second screen component 1003 is at a first position, the first opening is opened; and when the second screen component 1003 is at a second position, the second screen component 1003 closes the first opening to cover the light-sensitive surface and jointly displaying with the first screen component 1001.

In the embodiment of the present disclosure, the terminal device 1000 at least includes the first screen component 1001, the image acquisition component 1002 and the second screen component 1003.

In some embodiments, the terminal device 1000 may be a wearable electronic device and a mobile terminal, and the mobile terminal includes a mobile phone, a notebook computer and a tablet computer. There are no limits made in the embodiment of the present disclosure.

In the embodiment of the present disclosure, the first screen component 1001 is configured to display information.

In some embodiments, the first screen component includes a liquid crystal display screen, an Organic Light-Emitting Diode (OLED) display screen and a Cathode Ray Tube (CRT) display screen. There are no limits made in the embodiment of the present disclosure.

In the embodiment of the present disclosure, a shape and size of the first opening 1001a of the first screen component 1001 are adapted to a shape and size of the light-sensitive surface respectively.

It is to be noted that the shape of the first opening 1001a may also be set according to the shape of the light-sensitive surface of the image acquisition component. For example, when the shape of the light-sensitive surface is a circle, the first opening may also be arranged to be a circle; and when the shape of the light-sensitive surface is an ellipse, the first opening may also be arranged to be an ellipse.

Of course, the size of the first opening 1001a may also be set according to the size of the light-sensitive surface of the image acquisition component. For example, the size of the light-sensitive surface is provided to be equal to the size of the first opening, or, the size of the light-sensitive surface is provided to be less than the size of the first opening.

It is to be noted that the light-sensitive surface is made of a semiconductor material.

In some embodiments, the semiconductor material includes, but not limited to, a Charge Coupled Device (CCD) and a Complementary Metal Oxide Semiconductor (CMOS).

Of course, the light-sensitive surface may also be provided with different colors to meet different user requirements. For example, the light-sensitive surface may be arranged to be black or blue.

In some embodiments, the image acquisition component 1002 includes a camera, and the camera is a camera disposed on a surface where a screen of the terminal screen is located.

In the embodiment of the present disclosure, when the second screen component is at the first position, the first opening is opened; and when the second screen component is at the second position, the second screen component closes the first opening to cover the light-sensitive surface and performing joint displaying with the first screen component.

In an embodiment, when the second screen component moves to the first position, the second screen component is positioned on the back side of a display surface of the first screen component, and the first opening is opened. When the second screen component moves to the second position, the second screen component is possible to be exposed through the first opening, and the exposed second screen component performs joint displaying with the first screen component.

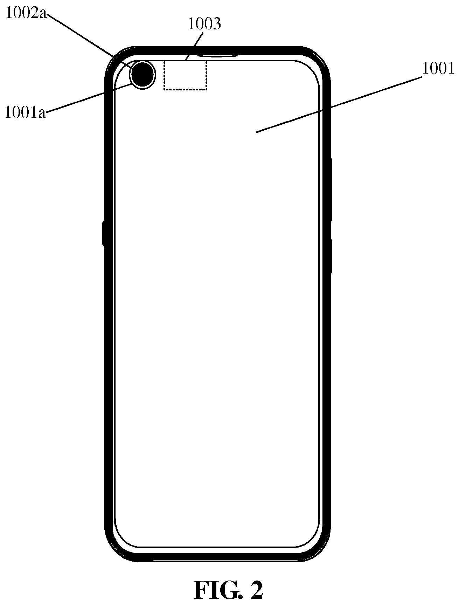

In some embodiments, as shown in FIG. 2, when the second screen component 1003 is at the first position, the first opening 1001a is opened, and the light-sensitive surface 1002a is exposed through the first opening 1001a. In such case, an image can be generated through the exposed light-sensitive surface 1002a by a user, and exposure of the light-sensitive surface for image generation can be implemented when the user takes a selfie.

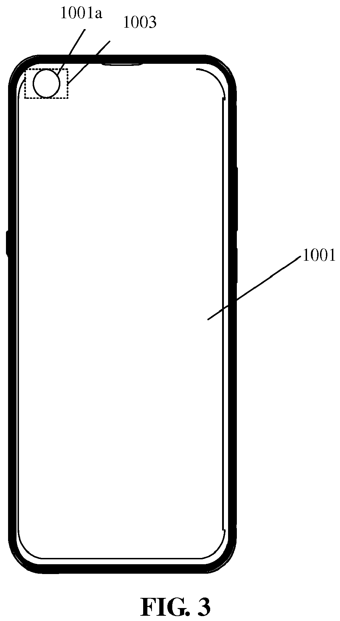

As shown in FIG. 3, when the second screen component 1003 is at the second position, the second screen component closes the first opening 1001a, the second screen component is exposed through the first opening 1001a, and the exposed second screen component 1003 is in a display state and performs joint displaying with the first screen component 1001. Therefore, the second screen component may cover the first opening and implement joint displaying with the first screen component to achieve a visually full-screen displaying effect.

It is to be noted that a size of the second screen component 1003 is matched with a size of the first opening. For example, the size of the second screen component 1003 may be equal to or greater than the size of the first opening. Therefore, the first opening may be covered so that the second screen component performs joint display with the first screen component to achieve the visual full-screen effect.

In the embodiment of the present disclosure, the first screen component performing joint displaying with the second screen component refers that the first screen component and the second screen component display different display parts of the same display content.

In some embodiments, when a webpage is displayed, the first screen component displays a first part of content in a display content of the webpage, and the second screen component displays a second part of content in a display content of the webpage. The first part of content and the second part of content consist of a display content of the webpage.

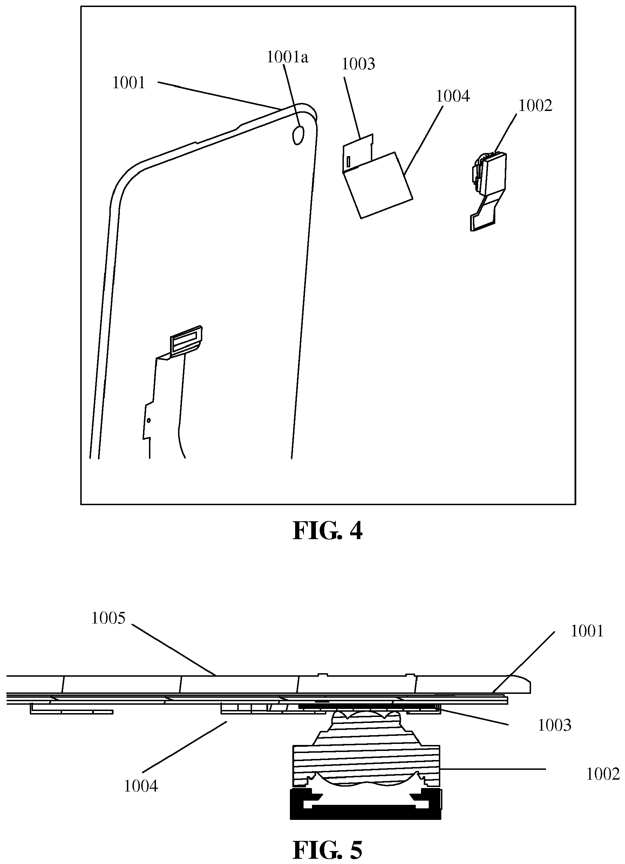

In an embodiment, as shown in FIG. 4, the terminal device further includes: a driving component.

The driving component is connected with the second screen component and configured to drive the second screen component to move between the first position and the second position.

It is to be noted that the first position may be provided to be a starting position and the second position may be provided to be an ending position, or the first position may be provided to be the ending position and the second position may be provided to be the starting position. That is, the second screen component may gradually move from the starting position to the ending position, and may also gradually move from the ending position to the starting position.

In some embodiments, the driving component includes, but not limited to, a magnetic driving component and a motor driving component.

In an embodiment, the terminal device 1000 further includes a protection component 1005, and the protection component 1005 covers the first screen component and is configured to protect the first screen component.

As shown in FIG. 5, the protection component 1005 covers the first screen component 1001. The image acquisition component 1002, the first screen component 1001 and the second screen component 1003 are located on different planes respectively. The second screen component 1003 is positioned between the first screen component 1001 and the image acquisition component 1002, and the driving component 1004 is connected with the second screen component 1003.

In some embodiments, the protection component 1005 may be made of a glass material.

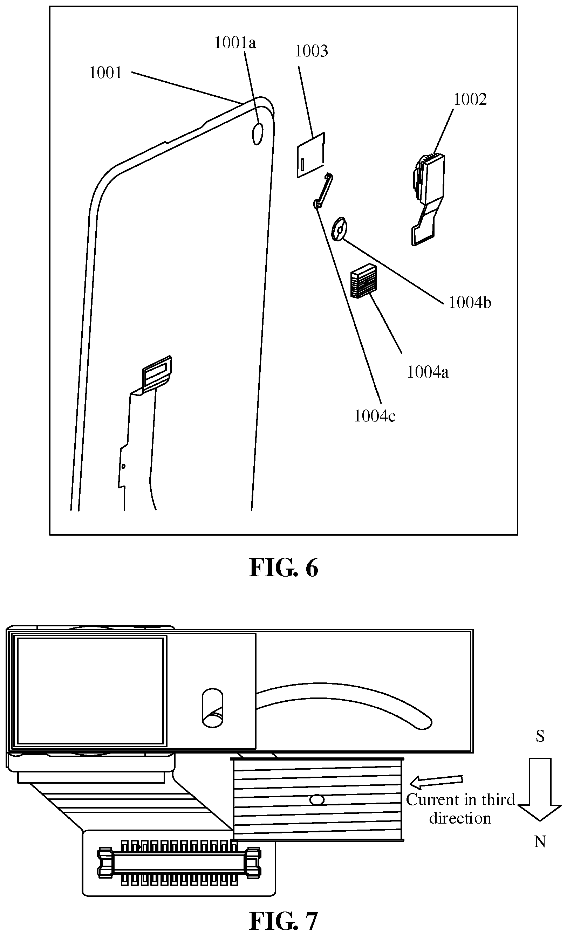

In an embodiment, FIG. 6 is a sixth structure diagram of a terminal device according to some embodiments of the present disclosure. As shown in FIG. 6, the driving component 1004 includes: a first magnetic portion 1004a, a second magnetic portion 1004b and a transmission portion 1004c.

The first magnetic portion 1004a includes a coil and is configured to generate a magnetic force based on a current in the coil;

The second magnetic portion 1004b is configured to rotate about a rotating axis under action of the magnetic force.

The transmission portion 1004c is connected with the second magnetic portion and the second screen component, configured to rotate along with rotation of the second magnetic portion and drive the second screen component to move between the first position and the second position.

In the embodiment of the present disclosure, a corresponding magnetic force may be generated based on the energizing coil. It is to be noted that a magnetic force in an opposite direction may be generated based on a current in the opposite direction of the coil.

In the embodiment of the present disclosure, the second magnetic portion 1004b rotates about the rotating axis under action of the magnetic force. That is, the second magnetic portion 1004b is magnetic, and there is an angle difference between a direction of a magnetic force of the second magnetic portion 1004b and a direction of the magnetic force of the first magnetic portion 1004a, and thus the second magnetic portion can rotate under action of the magnetic force.

In some embodiments, the second magnetic portion includes, but not limited to, a magnet.

In another embodiment, the transmission portion 1004c includes a first end and a second end opposite to the first end. The first end is connected with the second magnetic portion 1004b and configured to rotate along with rotation of the second magnetic portion. The second end is connected with the second screen component 1003 and is capable of driving the second screen component to move between the first position and the second position.

In an embodiment, as shown in FIG. 6, the first magnetic portion 1004a is configured to generate a magnetic force in a second direction based on a current in a first direction of the coil; and generate a magnetic force in a fourth direction based on a current in a third direction of the coil.

The second magnetic portion 1004b is configured to move about the rotating axis in a first clock direction under action of the magnetic force in the second direction; and move about the rotating axis in a second clock direction under action of the magnetic force in the fourth direction. The first clock direction and the second clock direction are opposite rotating directions, for example, the first clock direction is a counterclockwise direction and the second clock direction is a clockwise direction.

The transmission portion 1004c is configured to: when moving about the rotating axis in the first clock direction along with the second magnetic portion, drive the second screen component to move from the first position to the second position; and when moving about the rotating axis in the second clock direction along with the second magnetic portion, drive the second screen component to move from the second position to the first position.

That is, according to the embodiment of the present disclosure, magnetic forces in different directions are generated based on different current directions in the coil, the second magnetic portion rotates about the rotating axis towards different rotating directions based on the magnetic forces in different directions, and the transmission portion that rotates along with rotation of the second magnetic portion is utilized to drive the second screen component to move between the first position and the second position. It can be seen that according to the embodiment of the present disclosure, electric energy can be converted into mechanical energy, and thus a purpose of driving movement of the second screen component can be achieved.

In the embodiment of the present disclosure, the current in the first direction and the current in the third direction are currents in opposite direction, and the magnetic force in the second direction and the magnetic force in the fourth direction are magnetic forces opposite in direction.

In an embodiment, the transmission portion includes, but not limited to, a transmission rod.

In some embodiments, when it is required to sense the ambient light through the light-sensitive surface to generate the image, the second screen component is driven to move from the second position to the first position.

As shown in FIG. 7, the second screen component is at the second position, and the second screen component closes the first opening to cover the light-sensitive surface. In such case, the coil is energized, and the magnetic force in the fourth direction is generated based on the current in the third direction of the coil. The current in the third direction is a direction as shown by the arrow in FIG. 7, and the magnetic force in the fourth direction is a direction as shown by an arrow (S→N) in FIG. 7.

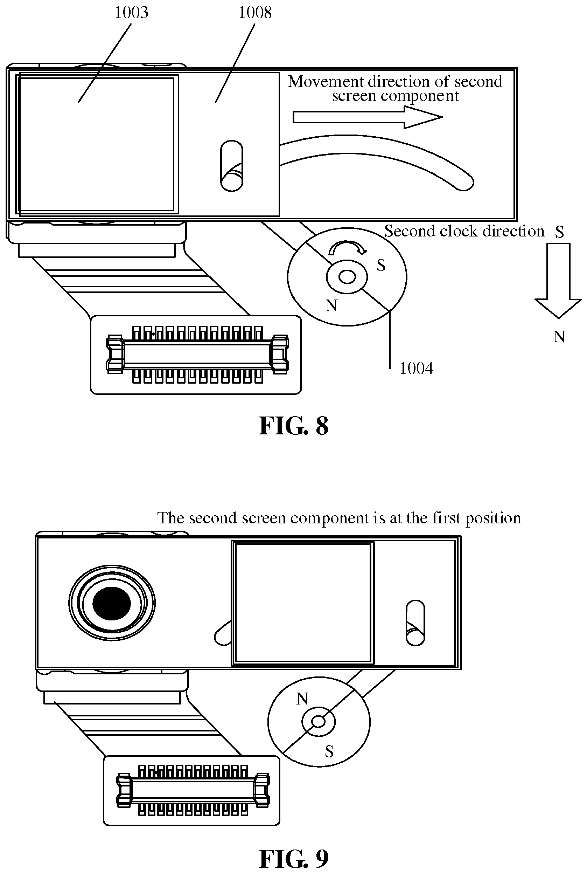

As shown in FIG. 8, the second magnetic portion moves about the rotating axis in the second clock direction under action of the magnetic force in the fourth direction. The second clock direction is a direction as shown by the arrow in FIG. 8. When the transmission portion moves about the rotating axis in the second clock direction depending on the second magnetic portion, a movement direction in which the second screen component is driven is a direction as shown by the arrow direction in FIG. 8.

As shown in FIG. 9, the second screen component is at the first position. In such case, the second screen component is disposed behind the first screen component, and the light-sensitive surface of the image acquisition component is exposed, so that the ambient light may be sensed through the light-sensitive surface for generation of image.

In some embodiments, when it is not required to sense the ambient light through the light-sensitive surface to generate the image, the second screen component is driven to move from the first position to the second position.

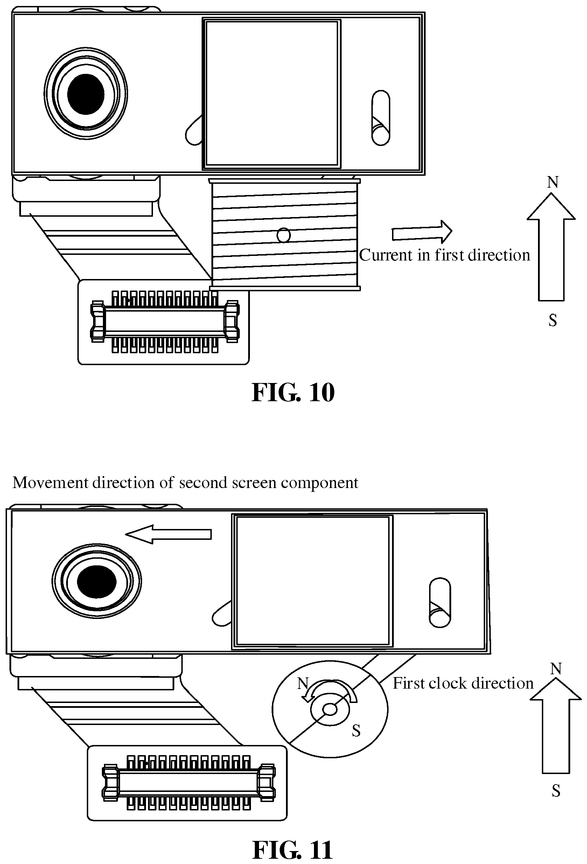

As shown in FIG. 10, the second screen component is at the first position, the second screen component is disposed behind the first screen component, and the first opening is opened to expose the light-sensitive surface. In such case, the coil is energized, and the magnetic force in the second direction is generated based on the current in the first direction of the coil. The current in the first direction is a direction as shown by the arrow direction in FIG. 10, and the magnetic force in the second direction is a direction as shown by the arrow (S→N) direction shown in FIG. 10.

As shown in FIG. 11, the second magnetic portion moves about the rotating axis in the first clock direction under action of the magnetic force in the second direction. The first clock direction is a direction as shown by the arrow in FIG. 11. When the transmission portion moves about the rotating axis in the second clock direction depending on the second magnetic portion, a movement direction in which the second screen component is driven is the arrow direction shown in FIG. 11.

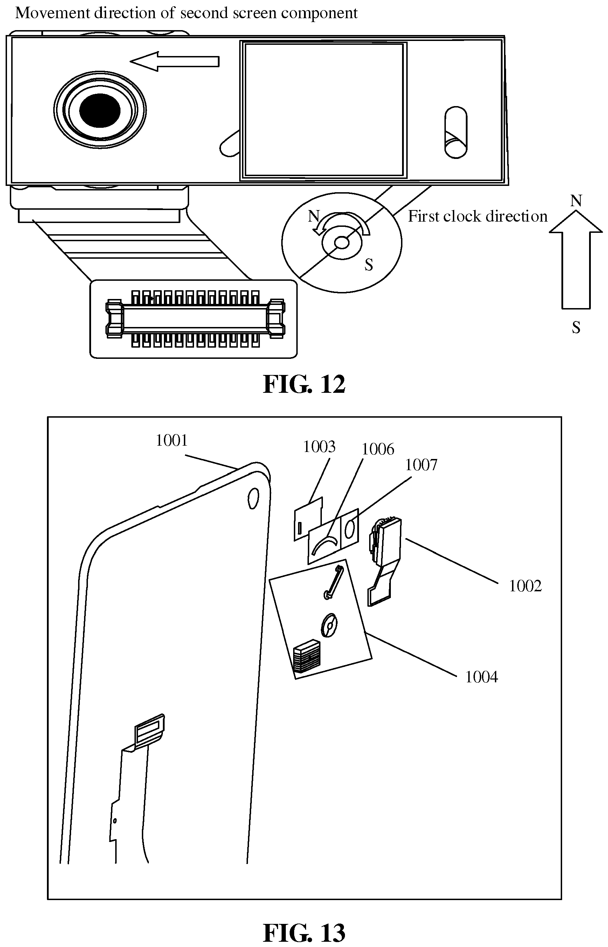

As shown in FIG. 12, the second screen component is at the second position. In such case, the second screen component closes the first opening to cover the light-sensitive surface and is exposed through the first opening.

In an embodiment, FIG. 13 is a seventh structure diagram of a terminal device according to some embodiments of the present disclosure. As shown in FIG. 13, the terminal device further includes: a movement trajectory limit component 1006 and a second opening 1007.

The movement trajectory limit component 1006 is positioned between the first position and the second position.

The driving component 1004 is configured to drive the second screen component to move along the movement trajectory limit component between the first position and the second position.

The second opening 1007 is positioned between the second screen component and the image acquisition component, aligned with the first opening and configured to when the first opening is opened, expose the light-sensitive surface of the image acquisition component for sensing of the ambient light.

That is, the movement trajectory limit component is configured to limit second screen component to move along the movement trajectory limit component only between the first position and the second position.

In another embodiment, the movement trajectory limit component includes a guide rail, and the second screen component may move along the guide rail.

In the embodiment of the present disclosure, the second opening is aligned with the first opening. A shape of the second opening may be set according to a design requirement, and for example, may be set to be a circle or another shape. The shape of the second opening may also be set according to the shape of the first opening and the shape of the light-sensitive surface, and for example, may be set to be the same shape as that of the light-sensitive surface and the first opening.

Of course, a size of the second opening may be set to be larger than or equal to the size of the first opening to achieve an effect of attractive appearance.

In an embodiment, as shown in FIG. 8, the terminal device further includes a connecting component 1008.

The connecting component 1008 is fixedly connected with the second screen component 1003.

The driving component 1004 is connected with the connecting component and configured to drive the connecting component to move to drive the second screen component to move along the movement trajectory limit component between the first position and the second position.

That is, in the embodiment of the present disclosure, the second screen component is fixedly connected with the connecting component and the driving component drives the connecting component to move, so as to drive the second screen component to move along the movement trajectory limit component between the first position and the second position.

In an embodiment, the movement trajectory limit component is provided with an arc moving groove.

The driving component is arranged to penetrate through the arc moving groove to be connected with the connecting component and configured to drive the connecting component to move along the arc moving groove.

That is, the driving component is arranged to penetrate through the arc moving groove to be connected with the connecting component and is capable of driving the connecting component to move along the arc moving groove, so as to drive the second screen component fixedly connected with the connecting component to move between the first position and the second position.

In another embodiment, a radian of the arc moving groove is centered on the rotating axis of the second magnetic portion.

In an embodiment, the connecting component is provided with a connecting groove; and the driving component sequentially is arranged to penetrate through the arc moving groove and then through the connecting groove to be connected with the connecting component.

That is, the driving component may penetrate through the arc moving groove firstly, then through the connecting groove, and is coupled with the connecting groove of the connecting component. The driving component drives the connecting component through a connection member to move along the arc moving groove, so as to drive the second screen component fixedly connected with the connecting component to move between the first position and the second position.

In another embodiment, the connecting groove of the connecting component is an ellipse, and when the second screen component moves, the connecting member moves in the ellipse.

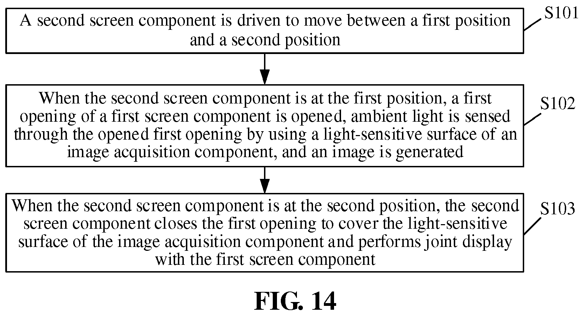

FIG. 14 is a flowchart showing a display method according to some embodiments of the present disclosure. As shown in FIG. 14, the display method includes the following operations in S101-S103.

In S101, a second screen component is driven to move between a first position and a second position.

In S102, when the second screen component is at the first position, a first opening of a first screen component is opened, an image acquisition component senses ambient light through the opened first opening by using a light-sensitive surface of the image acquisition component, and generates an image.

In S103, when the second screen component is at the second position, the second screen component closes the first opening to cover the light-sensitive surface of the image acquisition component and performs joint display with the first screen component.

In the embodiment of the present disclosure, when the image acquisition component is required to generate the image, the second screen component is at the first position, the first opening is opened, and the light-sensitive surface of the image acquisition component may sense the ambient light to generate the image; and when the image acquisition component is not required to generate the image, the second screen component is at the second position, the second screen component closes the first opening and is exposed through the first opening, and the exposed second screen component may perform joint display with the first screen component. Therefore, by adjustment of a position of the second screen component, on one hand, the light-sensitive surface can be exposed for selfie when a user is desired to take the selfie; and on the other hand, when the user requires the terminal device to display normally, the first opening can be covered by using the second screen component so as to achieve a visual full-screen display effect.

In an embodiment, the operation that the second screen component is driven to move between the first position and the second position includes that: the second screen component is driven, based on a driving component connected with the second screen component, to move between the first position and the second position.

In the embodiment of the present disclosure, when the image acquisition component is required to generate the image, the second screen component may be driven through the driving component to be at the first position; and when the image acquisition component is not required to generate the image, the second screen component may be driven through the driving component to be at the second position. Therefore, the second screen component can be driven intelligently according to different requirement, so that the light-sensitive surface is exposed for selfie when the user is desired to take a selfie and achieve the visual full-screen display effect when the user requires the terminal device to display normally.

In an embodiment, the operation that the second screen component is driven based on the driving component connected with the second screen component to move between the first position and the second position includes the following actions

A magnetic force is generated based on a current in a coil of a first magnetic portion of the driving component; a second magnetic portion of the driving component rotates about a rotating axis under action of the magnetic force; and the second screen component is driven to move between the first position and the second position through a transmission portion, which rotates along with rotation of the second magnetic portion, of the driving component.

In the embodiment of the present disclosure, the magnetic force is generated based on the current in the coil, then the second magnetic portion rotates about the rotating axis based on the magnetic force, and the second screen component is further driven to move between the first position and the second position through the transmission portion that rotates along with rotation of the second magnetic portion. It can be seen that electric energy can be converted into mechanical energy by using a principle of electromagnetic induction, and thus a purpose of driving movement of the second screen component can be achieved.

In another embodiment, the operation that the second screen component is driven based on the driving component connected with the second screen component to move between the first position and the second position includes the following action.

The second screen component is driven through the driving component connected with the second screen component to move along a movement trajectory limit component between the first position and the second position, the movement trajectory limit component being positioned between the first position and the second position.

In another embodiment, the operation that the second screen component is driven based on the driving component connected with the second screen component to move along the movement trajectory limit component between the first position and the second position includes the following actions.

A connecting component is driven through the driving component connected with the connecting component fixed on the second screen component to move; and the second screen component is driven through the moving connecting component to move along the movement trajectory limit component between the first position and the second position.

In an embodiment, the operation that the magnetic force is generated based on the current in the coil of the first magnetic portion of the driving component includes the following action.

A magnetic force of a second direction is generated based on a current in a first direction of the coil; and a magnetic force in a fourth direction is generated based on a current in a third direction of the coil.

In the embodiment of the present disclosure, magnetic forces in different directions are generated based on currents in different directions within the coil. The current in the first direction and the current in the third direction are currents in opposite direction. The magnetic force in the second direction and the magnetic force in the fourth direction are magnetic forces in opposite direction.

In an embodiment, the operation that the second magnetic portion of the driving component rotates about the rotating axis under action of the magnetic force includes the following actions.

The second magnetic portion rotates about the rotating axis in a first clock direction under action of the magnetic force in the second direction; or, the second magnetic portion rotates about the rotating axis in a second clock direction under action of the magnetic force in the fourth direction. The first clock direction and the second clock direction are opposite rotating directions.

In the embodiment of the present disclosure, the second magnetic portion rotates about the rotating axis in different clock directions based on the magnetic forces in different directions, and thus the second magnetic portion can rotate by virtue of the magnetic forces.

In an embodiment, the operation that the second screen component is driven to move between the first position and the second position by using the transmission portion, which rotates along with rotation of the second magnetic portion, of the driving component includes the following actions.

The second screen component is driven to move from the first position to the second position by using a second end of the transmission portion that rotates along with rotation of the second magnetic portion about the rotating axis in the first clock direction; or, the second screen component is driven to move from the second position to the first position by using the second end of the transmission portion that rotates along with rotation of the second magnetic portion about the rotating axis in the second clock direction.

In the embodiment of the present disclosure, magnetic forces in different directions are firstly generated based on different current directions in the coil, and then the second magnetic portion rotates about the rotating axis in different rotating directions based on the magnetic forces in different directions, so as to drive the second screen component to move between the first position and the second position. It can be seen that electric energy is converted into mechanical energy by using a principle of electromagnetic induction, and thus the purpose of driving movement of the second screen component is achieved.

Other implementation solutions of the present disclosure will be apparent to those skilled in the art from consideration of the specification and practice of the present disclosure. This disclosure is intended to cover any variations, uses, or adaptations of the present disclosure following the general principles thereof and including such departures from the present disclosure as come within known or customary practice in the art. It is intended that the specification and examples be considered as exemplary only, with a true scope and spirit of the present disclosure being indicated by the following claims.

The terms "first" and "second" are used for descriptive purposes only and are not to be construed as indicating or implying a relative importance or implicitly indicating the number of technical features indicated. Thus, elements referred to as "first" and "second" can include one or more of the features either explicitly or implicitly. In the description of the present disclosure, "a plurality" indicates two or more unless specifically defined otherwise.

In the present disclosure, the terms "connected", "coupled", "fixed" and the like shall be understood broadly, and can be either a fixed connection or a detachable connection, or integrated, unless otherwise explicitly defined. These terms can refer to mechanical or electrical connections, or both. Such connections can be direct connections or indirect connections through an intermediate medium. These terms can also refer to the internal connections or the interactions between elements. The specific meanings of the above terms in the present disclosure can be understood by those of ordinary skill in the art on a case-by-case basis.

In the description of the present disclosure, the terms "one embodiment", "some embodiments", "example", "specific example" or "some examples" and the like can indicate a specific feature described in connection with the embodiment or example, a structure, a material or feature included in at least one embodiment or example. In the present disclosure, the schematic representation of the above terms is not necessarily directed to the same embodiment or example.

Moreover, the particular features, structures, materials, or characteristics described can be combined in a suitable manner in any one or more embodiments or examples. In addition, various embodiments or examples described in the specification, as well as features of various embodiments or examples, can be combined and reorganized.

While this specification contains many specific implementation details, these should not be construed as limitations on the scope of any claims, but rather as descriptions of features specific to particular implementations. Certain features that are described in this specification in the context of separate implementations can also be implemented in combination in a single implementation. Conversely, various features that are described in the context of a single implementation can also be implemented in multiple implementations separately or in any suitable subcombination.

Moreover, although features can be described above as acting in certain combinations and even initially claimed as such, one or more features from a claimed combination can in some cases be excised from the combination, and the claimed combination can be directed to a subcombination or variation of a subcombination.

As such, particular implementations of the subject matter have been described. Other implementations are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking or parallel processing can be utilized.

It is intended that the specification and embodiments be considered as examples only. Other embodiments of the disclosure will be apparent to those skilled in the art in view of the specification and drawings of the present disclosure. That is, although specific embodiments have been described above in detail, the description is merely for purposes of illustration. It should be appreciated, therefore, that many aspects described above are not intended as required or essential elements unless explicitly stated otherwise.

Various modifications of, and equivalent acts corresponding to, the disclosed aspects of the example embodiments, in addition to those described above, can be made by a person of ordinary skill in the art, having the benefit of the present disclosure, without departing from the spirit and scope of the disclosure defined in the following claims, the scope of which is to be accorded the broadest interpretation so as to encompass such modifications and equivalent structures.

It will be appreciated that the present disclosure is not limited to the exact construction that has been described above and illustrated in the accompanying drawings, and that various modifications and changes may be made without departing from the scope thereof. It is intended that the scope of the present disclosure only be limited by the appended claims.

## Claims

1. A terminal device, **characterized by** the terminal device comprising:
a first screen component (1001), having a first opening (1001a);
an image acquisition component (1002), having a light-sensitive surface and configured to sense ambient light through the light-sensitive surface to generate an image when the first opening (1001a) is opened; and
a second screen component (1003),
wherein, when the second screen component (1003) is at a first position, the first opening (1001a) is opened and, when the second screen component (1003) is at a second position, the second screen component (1003) closes the first opening (1001a) to cover the light-sensitive surface and performs joint display with the first screen component (1001).

2. The terminal device of claim 1, further comprising:
a driving component (1004), connected with the second screen component (1003) and configured to drive the second screen component (1004) to move between the first position and the second position.

3. The terminal device of claim 2, wherein the driving component (1004) comprises:
a first magnetic portion (1004a), comprising a coil and configured to generate a magnetic force based on a current within the coil;
a second magnetic portion (1004b), configured to rotate about a rotating axis under action of the magnetic force; and
a transmission portion (1004c), connected with the second magnetic portion (1004b) and the second screen component (1003), and configured to rotate along with rotation of the second magnetic portion (1004b) to drive the second screen component (1003) to move between the first position and the second position.

4. The terminal device of claim 3, wherein
the first magnetic portion (1004a) is configured to: generate a magnetic force in a second direction based on a current in a first direction of the coil, and generate a magnetic force in a fourth direction based on a current in a third direction of the coil;
the second magnetic portion (1004b) is configured to: move about the rotating axis in a first clock direction under action of the magnetic force in the second direction, and move about the rotating axis in a second clock direction under action of the magnetic force in the fourth direction, the first clock direction and the second clock direction being opposite rotation directions; and
the transmission portion (1004c) is configured to:
when moving about the rotating axis in the first clock direction along with rotation of the second magnetic portion (1004b), drive the second screen component (1003) to move from the first position to the second position; and
when moving about the rotating axis in the second clock direction along with rotation of the second magnetic portion (1004b), drive the second screen component (1003) to move from the second position to the first position.

5. The terminal device of any one of claims 2 to 4, further comprising:
a movement trajectory limit component (1006), positioned between the first position and the second position, wherein the driving component (1004) is configured to drive the second screen component (1003) to move along the movement trajectory limit component (1006) between the first position and the second position; and
a second opening (1007), positioned between the second screen component (1003) and the image acquisition component (1002), wherein the second opening (1007) is aligned with the first opening (1001a) and configured to expose, when the first opening is opened, the light-sensitive surface of the image acquisition component (1003) for sensing the ambient light.

6. The terminal device of claim 5, further comprising:
a connecting component (1008), fixedly connected with the second screen component (1003),
wherein the driving component (1004) is connected with the connecting component (1008) and configured to drive the second screen component (1003) to move along the movement trajectory limit component (1006) between the first position and the second position by driving movement of the connecting component (1008).

7. The terminal device of claim 6, wherein
the movement trajectory limit component (1006) is provided with an arc moving groove; and
the driving component (1004) is arranged to penetrate through the arc moving groove to be connected with the connecting component (1008) and configured to drive the connecting component (1008) to move along the arc moving groove.

8. The terminal device of claim 7, wherein
the connecting component (1008) is provided with a connecting groove; and
the driving component (1004) sequentially penetrate through the arc moving groove and the connecting groove to be connected with the connecting component (1008).

9. A display method, **characterized by** the method comprising:
driving (S101) a second screen component to move between a first position and a second position, wherein, when the second screen component is at the first position, a first opening of a first screen component is opened and, when the second screen component is at the second position, the first opening of the first screen component is closed;
sensing (S102), when the first opening of a first screen component is at the first position, ambient light by a light-sensitive surface of an image acquisition component through the opened first opening to generate an image; and
covering (S103), when the first opening of the first screen component is at the second position, by the second screen component, the light-sensitive surface of the image acquisition component and performing joint display with the first screen component.

10. The method of claim 9, wherein driving (S101) the second screen component to move between the first position and the second position comprises:
driving the second screen component to move between the first position and the second position by a driving component connected with the second screen component.

11. The method of claim 10, wherein driving the second screen component to move between the first position and the second position by the driving component connected with the second screen component comprises:
generating a magnetic force based on a current in a coil of a first magnetic portion of the driving component;
rotating about a rotating axis by the second magnetic portion of the driving component under action of the magnetic force; and
driving the second screen component to move between the first position and the second position through a transmission portion of the driving component that rotates along with rotation of the second magnetic portion.

12. The method of claim 11, wherein generating the magnetic force based on the current in the coil of the first magnetic portion of the driving component comprises:
generating a magnetic force in a second direction based on a current in a first direction of the coil; and
generating a magnetic force in a fourth direction based on a current in a third direction of the coil.

13. The method of claim 12, wherein rotating about the rotating axis by the second magnetic portion of the driving component under action of the magnetic force comprises:
rotating about the rotating axis in a first clock direction by the second magnetic portion under action of the magnetic force in the second direction;
or,
rotating about the rotating axis in a second clock direction by the second magnetic portion under action of the magnetic force in the fourth direction, the first clock direction and the second clock direction being opposite rotation directions.

14. The method of claim 13, wherein driving the second screen component to move between the first position and the second position through the transmission portion of the driving component that rotates along with rotation of the second magnetic portion comprises:
driving the second screen component to move from the first position to the second position through a second end of the transmission portion that rotates along with rotation of the second magnetic portion about the rotating axis in the first clock direction;
or,
driving the second screen component to move from the second position to the first position through the second end of the transmission portion that rotates along with rotation of the second magnetic portion about the rotating axis in the second clock direction.

15. The method of claim 9, wherein performing, by the second screen component, the joint display with the first screen component comprises:
displaying display parts of a display content through the first screen component and the second screen component.
